# EUROPÄISCHE PATENTANMELDUNG

(11) **EP 4 439 099 A1**
(43) Veröffentlichungstag der Anmeldung: **02.10.2024**
(21) Anmeldenummer: 24163022.7
(22) Anmeldetag: 12.03.2024
(51) Int. Cl.: G01R 31/28, H03K 17/96, H03K 17/955

(54) **SENSOR-SCHALTUNG UND MESSSYSTEM FÜR KAPAZITIVE SENSOREN**

(30) Priorität: 29.03.2023 DE 102023107966
(71) Anmelder: Elmos Semiconductor SE, 44227 Dortmund (DE)
(72) Erfinder: Stellberger, Achim, 44227 Dortmund (DE); Frank, Thomas, 76676 Graben-Neudorf (DE)
(74) Vertreter: Durm Patentanwälte PartG mbB

(57) **Zusammenfassung**

Eine Sensor-Schaltung (20) für kapazitive Sensoren (50) umfasst einen DC-Referenztreiber (22) zum Erzeugen eines DC-Referenzsignals, einen Sensor-Treiber (24) zum Erzeugen eines AC-Signals, mit einem Ausgangsport (28), um das AC-Signal zum Speisen der kapazitiven Sensoren (50) auszugeben, und mit einem Stromausgangsport (29), um einen zu dem AC-Signal korrespondierenden Messstrom auszugeben, und mehrere Sensor-Ports (40) zum Anschluss an je einen kapazitiven Sensor (50). Die Sensor-Schaltung (20) umfasst eine Schaltmatrix (30) zwischen den Sensor-Ports (40) und den Treibern, wobei die Schaltmatrix (30) für jeden Sensor-Port (40) einen Schaltpfad mit einem RT-Schalter (34), einem Sensor-Schalter (36) und einem Lastwiderstand (32) aufweist. Eine DC-Entkopplung (62) zwischen Schaltmatrix (30) und kapazitiven Sensor (50) dient zum DC-Entkoppeln der Schaltmatrix (30) von den kapazitiven Sensoren (50). Die Sensor-Schaltung (20) kann einen Selbsttest durchführen, bei dem der Sensor-Treiber (24) ein DC-Signal ausgibt, so dass eine Spannungsdifferenz zwischen dem DC- Referenztreiber (22) und dem Sensor-Treiber (24) gebildet wird, die über der Schaltmatrix (30) anliegt. Der während des Selbsttests über die Schaltmatrix (30) fließende Strom wird gemessen. Die Erfindung betrifft auch ein Messsystem mit einer Sensor-Schaltung (20) und kapazitiven Sensoren (50).

## Beschreibung

Die vorliegende Erfindung betrifft eine Sensor-Schaltung für kapazitive Sensoren umfassend einen DC-Referenztreiber zum Erzeugen eines DC-Referenzsignals, einen Sensor-Treiber zum Erzeugen eines Sinussignals zum Speisen der kapazitiven Sensoren, mehrere Sensor-Ports zum Anschluss an je einen kapazitiven Sensor und eine Schaltmatrix zum Herstellen einer Verbindung der Sensor-Ports mit den Treibern. Die Erfindung betrifft weiter ein kapazitives Messsystem zum Auswerten eines kapazitiven Sensors umfassend einen Sensor, eine Sensor-Schaltung für den kapazitiven Sensor und eine DC-Entkopplung zwischen Sensor-Schaltung und Sensor. Des Weiteren betrifft die Erfindung entsprechende Verfahren zum Ausführen eines integrierten Selbsttests für sicherheitsrelevante Komponenten einer Sensor-Schaltung für kapazitive Sensoren.

Kapazitive Sensoren und entsprechende Messsysteme oder Sensor-Schaltungen werden in vielen Bereichen des täglichen Lebens angewandt, beispielsweise bei berührungslosen Sensoren oder Touchsensoren. Sie sind insbesondere im Automobilbereich und hier in Fahrzeugen zu finden. Beispielsweise kommen kapazitive Sensoren zum Einsatz, wenn überprüft werden soll, dass ein Fahrzeugführer das Lenkrad umgreift und das Fahrzeug aktiv führen kann oder aktiv führt. Bei autonomen oder teilautonomen Systemen wird in regelmäßigen Abständen überprüft, ob der Fahrzeugführer eine Hand am Lenkrad hat, um festzustellen, dass er wach ist und gegebenenfalls das Fahrzeug manuell führen könnte.

Ein anderes Einsatzgebiet im Automobilbereich ist die Erkennung einer Sitzbelegung. Wenn ein Passagier auf einem Sitz im Fahrzeug sitzt, muss er angeschnallt sein. Hierzu wird zum einen die Sitzbelegung erfasst und zum anderen kontrolliert, ob das Gurtschloss von dem Gurt geschlossen ist. Dies muss immer dann der Fall sein, wenn der Sitz belegt wird. Es gibt eine Vielzahl von kapazitiven Sensoren, die diese Überprüfung leisten.

Beispielsweise schlägt die DE 11 2010 004 513 B4 ein System zum Erkennen einer Belegung in einem Fahrzeug vor, bei dem nicht nur die generelle Belegung des Sitzes erkannt wird, sondern mit dem auch unterschieden werden kann, ob eine Person oder ein anderes Objekt auf dem Sitz angeordnet ist, das ein deutlich geringeres Gewicht aufweist als eine Person. Hierzu wird neben der rein kapazitiven Erfassung der Anwesenheit einer Person oder eines Gegenstands auch die Möglichkeit zum Erkennen einer relativen Kraft vorgeschlagen. Dabei werden beispielsweise mehrere Sensoren und eine Schirm-Elektrode eingesetzt, die mit einer Schaltmatrix unterschiedlich verschaltet werden können.

Da es sich beim Einsatz derartiger kapazitiver Sensoren im Automobilbereich um sicherheitsrelevante Bauteile handelt, besteht ein Bedarf zu überprüfen, ob alle Komponenten dieser Bauteile einwandfrei funktionieren, insbesondere Schalter zum Umschalten einzelner interner Schaltpfade.

Gelöst wird die vorliegende Aufgabe durch eine Sensor-Schaltung mit den Merkmalen des Anspruchs 1, durch ein kapazitives Messsystem mit den Merkmalen des Anspruchs 9 und durch ein Verfahren mit den Merkmalen des Anspruchs 15.

Im Rahmen der Erfindung wurde erkannt, dass die Überprüfung der einzelnen Komponenten innerhalb der Sensor-Schaltung durch einen integrierten Selbsttest durchgeführt werden kann. Dabei ist es wichtig, dass insbesondere die Schalter und Widerstände, die in Leitungspfaden in der Schaltmatrix verwendet werden, einwandfrei funktionieren. Diese Komponenten lassen sich mittels der Erfindung zuverlässig und einfach überprüfen, ohne dass zusätzliche Bauteile notwendig sind.

In einem Aspekt betrifft die vorliegende Erfindung eine Sensor-Schaltung für kapazitive Sensoren, die einen DC-Referenztreiber zum Erzeugen eines DC-Referenzsignals, einen Sensor-Treiber zum Erzeugen eines Sinussignals, mehrere Sensor-Ports zum Anschluss an je einen kapazitiven Sensor und eine Schaltmatrix zum Herstellen einer Verbindung der Sensor-Ports mit den Treibern umfasst. Der Sensor-Treiber hat einen Ausgangsport, um das Sinussignal zum Speisen der kapazitiven Sensoren auszugeben. Er umfasst weiter einen Stromausgangsport, um einen zu dem am Ausgangsport ausgegebenen Sinussignal korrespondierenden Messstrom auszugeben. Dieser Messstrom kann für eine Messung und Überprüfung der sicherheitsrelevanten Komponenten verwendet werden. Die Schaltmatrix hat für jeden Sensor-Port einen Leitungspfad, der einen RT-Schalter (Schalter nahe am DC-Referenztreiber), einen Sensor-Schalter und einen Lastwiderstand umfasst. Bevorzugt sind der RT-Schalter und der Lastwiderstand in Reihe geschaltet zwischen dem DC-Referenztreiber und dem jeweiligen Sensor-Port. Der Sensor-Schalter ist zwischen dem Sensor-Port und dem Sensor-Treiber geschaltet.

Die Schaltmatrix ermöglicht es, einen der Sensor-Ports der Sensor-Schaltung mit dem Sensor-Treiber zu verbinden, sodass während des Betriebs der Sensor-Schaltung und zum Messen angeschlossener Sensoren das von dem Sensor-Treiber ausgegebene Sinussignal zu dem an dem entsprechenden Sensor-Port angeschlossenen kapazitiven Sensor gelangt. Die anderen Sensor-Ports sind von dem Sensor-Treiber entkoppelt, indem der Sensor-Schalter in den entsprechenden Leitungspfaden geöffnet wird. Diese anderen Sensor-Ports werden mit einem DC-Referenzsignal aus dem DC-Referenztreiber versorgt, um die Ports auf ein definiertes Potential zu heben. Dazu wird der RT-Schalter in Reihe zu dem Lastwiderstand geschlossen.

Eine Änderung der Impedanz des kapazitiven Sensors führt zu einer Änderung des von dem Sensor-Treiber abgegebenen Stroms. Dieser Strom wird zusätzlich an einem Stromausgangsport gemessen, sodass sich die Impedanzänderung in einer Stromänderung widerspiegelt. Der Messstrom am Stromausgangsport wird einer Auswerteeinheit zugeführt, die bevorzugt eine analoge Signalverarbeitungseinheit und einen Filter umfassen kann, um ein Signal für einen Analog-Digital-Wandler zur Verfügung zu stellen, damit beispielsweise das Stromsignal als Digitalsignal weiterverarbeitet werden kann.

Die zwischen der Schaltmatrix und dem kapazitiven Sensor angeordnete DC-Kopplung sorgt für eine Gleichstromentkopplung. Sie ist jedoch für das von dem Sensor-Treiber zur Detektion des kapazitiven Sensors ausgegebene AC-Signal oder Sinussignal durchlässig. Lediglich Gleichstromsignale werden von der DC-Kopplung unterdrückt. Dies kann beispielsweise durch einen Kondensator oder eine Kapazität erfolgen.

Erfindungsgemäß ist die Sensor-Schaltung dazu ausgebildet, einen Selbsttest durchzuführen, bei dem der Sensor-Treiber ein DC-Signal ausgibt. Der Sensor-Treiber ist also dazu ausgebildet, sowohl ein AC- oder Sinussignal als auch ein DC-Signal an seinem Ausgang auszugeben. Durch die Erzeugung einer Gleichspannung wird eine Spannungsdifferenz zwischen dem DC-Referenztreiber und dem Sensor-Treiber gebildet, die über der Schaltmatrix anliegt. Dabei wird während des Selbsttests ein Schaltpfad zwischen DC-Referenztreiber und Sensor-Treiber geschlossen, wobei der Schaltpfad einen RT-Schalter, einen Sensor-Schalter und einen Lastwiderstand umfasst, die in Reihe geschaltet sind. Durch die erzeugte Spannungsdifferenz wird ein über die Schaltmatrix fließender Strom hervorgerufen, der gemessen werden kann. Vorzugsweise wird der Strom am Stromausgangsport des Sensor-Treibers abgegriffen und gemessen. Dies erfolgt beispielsweise mittels der Auswerteeinheit.

Auf diese Weise lassen sich die Komponenten in einem Schaltpfad der Schaltmatrix für jeden Sensor-Port überprüfen, wobei der Lastwiderstand, der RT-Schalter und der Sensor-Schalter einem Sensor-Port zugeordnet sind. Die einzelnen Sensor-Port werden nacheinander geprüft.

Damit lediglich die sicherheitsrelevanten Bauteile in dem Schaltpfad für einen Sensor-Port gemessen werden, werden die anderen Sensor-Ports der Sensor-Schaltung von den beiden Treibern, DC-Referenztreiber und Sensor-Treiber, getrennt, indem die jeweiligen RT-Schalter und Sensor-Schalter, die zu den Sensor-Ports gehören, geöffnet werden.

In einem weiteren Aspekt betrifft die vorliegende Erfindung ein kapazitives Messsystem zum Auswerten eines kapazitiven Sensors, das den Sensor, bevorzugt mit einer Sensor-Elektrode, eine Sensor-Schaltung für den kapazitiven Sensor und eine DC-Entkopplung zwischen Sensor-Schaltung und Sensor umfasst. Die Sensor-Schaltung umfasst dabei einen DC-Referenztreiber zum Erzeugen eines DC-Referenzsignals, einen Sensor-Treiber zum Erzeugen und Ausgeben eines AC-Signals, beispielsweise eines Sinussignals, an einem Ausgangsport zum Speisen des Sensors, einen Sensor-Port zum Anschluss an den Sensor und eine Schaltmatrix zum Herstellen einer Verbindung des Sensor-Ports mit den beiden Treibern, also dem DC-Referenztreiber und dem Sensor-Treiber. Vorzugsweise umfasst die Sensor-Schaltung mehrere Sensor-Ports, um mehrere kapazitive Sensoren ansteuern und auswerten zu können.

Erfindungsgemäß weist der Sensor-Treiber einen Stromausgangsport auf, um einen zu dem am Ausgangsport ausgegebenen AC-Signal bzw. Sinussignal korrespondierenden Messstrom auszugeben. Die Schaltmatrix umfasst einen RT-Schalter, einen Sensor-Schalter und einen Lastwiderstand, der in Reihe mit dem RT-Schalter geschaltet ist. Mittels dieser Komponenten erlaubt die Schaltmatrix eine Verbindung des Sensor-Ports mit dem DC-Referenztreiber und/oder dem Sensor-Treiber.

Die Sensor-Schaltung ist erfindungsgemäß dazu ausgebildet, einen Selbsttest durchzuführen, bei dem der Sensor-Treiber ein DC-Signal ausgibt, sodass eine Spannungsdifferenz zwischen dem DC-Referenztreiber und dem Sensor-Treiber gebildet wird, die über der Schaltmatrix anliegt. Während des Selbsttests kann der über die Schaltmatrix fließende Strom gemessen werden, beispielsweise indem der an dem Stromausgangsport ausgegebene Messstrom ausgewertet wird.

Damit während des Selbsttests eine Spannungsdifferenz zwischen dem DC-Referenztreiber und dem Sensor-Treiber gebildet wird, wird für einen zugehörigen Sensor-Port ein Schaltpfad gebildet, indem der RT-Schalter und der Sensor-Schalter des betreffenden Sensor-Ports geschlossen werden. Zu allen anderen Sensor-Ports werden die zugehörigen RT-Schalter und Sensor-Schalter vorzugsweise geöffnet, sodass diese Ports unbeschaltet sind und von den Treibern entkoppelt sind. Es wird folglich bevorzugt stets lediglich ein Schaltpfad eines Sensor-Ports gemessen.

Weitere Aspekte der Erfindung betreffen ein entsprechendes Verfahren und ein Computerprogrammprodukt mit Programmcode zum Durchführen der Schritte des Verfahrens, wenn der Programmcode auf einem Computer ausgeführt wird, sowie ein Speichermedium, auf dem ein Computerprogramm gespeichert ist, das, wenn es auf einem Computer ausgeführt wird, eine Ausführung des hierin beschriebenen Verfahrens bewirkt. Das Verfahren kann ganz oder teilweise auch in Hardware implementiert sein.

Die Schaltmatrix der Sensor-Schaltung verbindet den Sensor-Treiber mit den verschiedenen kapazitiven Sensoren, die angeschlossen sind und deren Impedanz nacheinander gemessen werden soll. Die Funktion der Schaltmatrix und die sicherheitsrelevanten Bauteile müssen regelmäßig überprüft werden bei Sensoren im Fahrzeug. Das erfindungsgemäße Messsystem beruht auf dem Prinzip, dass die Sensoren zur Messung ihrer Impedanz mit einem AC-Signal angesteuert werden. Es besteht keine DC-Pfade zwischen den Sensor-Ports und der Masse (Ground GND) oder der Spannungsversorgung. Dies wird durch die DC-Entkopplung gewährleistet. Zur Überprüfung der Schaltmatrix und der Widerstände in der Schaltung wird bevorzugt zyklisch zwischen zwei Messungen ein Selbsttest (BIST) ausgeführt. Dazu werden nur die vorhandenen Schaltungen der Sensor-Schaltung aus der applikativen Impedanzmessung verwendet. Zusätzlichen Messschaltungen, Komparatoren oder Schalter werden nicht gebraucht.

Der Selbsttest erfolgt mit DC-Spannungen, die anstelle der AC-Signale von dem Sensor-Treiber und gegebenenfalls von einem Schirm-Treiber für eine Schirm-Elektrode ausgegeben werden. Der Strom wird am Stromausgang mit Hilfe des gleichen Signalpfads gemessen, der auch für die Impedanzmessung verwendet wird. Der Strom wird für die unterschiedlichen Schalterstellungen von RT-Schalter und Sensor-Schalter gemessen. Er muss etwa Null sein, wenn einer der Schalter geöffnet ist. Sind beide Schalter geschlossen, muss der (digitalisierte) Strom zwischen definierten Grenzen liegen, die in einer Speichereinheit gespeichert sind und in einem Produktionstest ermittelt werden können.

Bevorzugte Ausgestaltungen der Erfindung werden in den abhängigen Ansprüchen beschrieben. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen. Insbesondere können das Verfahren und das Computerprogrammprodukt entsprechend der für die Sensor-Schaltung und der für das Messsystem in den abhängigen Ansprüchen beschriebenen Ausgestaltungen ausgeführt sein.

Erfindungsgemäß werden die sicherheitsrelevanten Komponenten der Sensor-Schaltung in einem Selbsttest überprüft, so dass eine Diagnose der Integrität der Messpfade des Messsystems erzielt wird. Dabei werden die Schaltungsteile der Sensor-Schaltung, die beispielsweise in einem IC genutzt und für die eigentliche Applikation für eine AC-Kapazitätsmessung verwendet werden, für eine DC-Widerstandsmessung eingesetzt. Es sind keine zusätzlichen Bauteile wie Komparatoren, Messeinrichtungen oder Schalter benötigt.

In einer bevorzugten Ausführungsform umfasst die Sensor-Schaltung wenigstens vier Sensor-Ports, bevorzugt wenigstens acht Sensor-Ports. Derartige Schaltungen bilden die meisten Einsatzanforderungen für kapazitive Sensoren ab. Auf diese Weise lassen sich Sensor-Elemente mit vier bzw. acht kapazitiven Sensoren verwenden. In einzelnen Fällen hat es sich als vorteilhaft erwiesen, wenn die Sensor-Schaltung 16 Sensor-Ports aufweist, sodass insgesamt 16 kapazitive Sensoren angeschlossen werden können.

Eine bevorzugte Ausführungsform der Sensor-Schaltung sieht vor, dass während des Selbsttests die Schaltmatrix derart geschaltet wird, dass die einzelnen Sensor-Ports abwechselnd angesteuert werden. Somit können alle Sensor-Ports und die zwischen Sensor-Port und Sensor-Treiber sowie zwischen dem Sensor-Port und DC-Referenztreiber vorhandenen Schalter und Lastwiderstände überprüft werden.

In einer weiteren bevorzugten Ausführungsform werden die anderen Sensor-Ports, die nicht angesteuert werden und deren zugehörige Komponenten nicht überprüft werden, auf ein definiertes Potential gelegt. Besonders bevorzugt werden sie von der Schaltmatrix entkoppelt.

In einer weiter bevorzugten Ausführungsform der Sensor-Schaltung werden während des Selbsttests der RT-Schalter und/oder der Sensor-Schalter eines Schaltpfads für einen zugehörigen Sensor-Port in verschiedene Schaltstellungen geschaltet. In einer Ausführungsform sind sowohl der RT-Schalter als auch der Sensor-Schalter geschlossen. In diesem Fall muss der ermittelte Stromwert oder Strommesswert bzw. sein digitalisierter Wert zwischen definierten Grenzen liegen. Diese Grenzen können fest definiert werden oder nach der Produktion in Produktionstests ermittelt werden. Werden die Grenzwerte in Produktionstests ermittelt, sind engere Grenzen möglich, da herstellungsbedingte Toleranzen auskalibriert werden können. Die Grenzwerte sind bevorzugt in einem nicht-volatilen Speicher abgelegt.

Ist mindestens einer der beiden Schalter (RT-Schalter und Sensor-Schalter) im Schaltpfad geöffnet, so muss der Wert für den Strom gleich Null sein.

Die erfindungsgemäße Sensor-Schaltung hat den Vorteil, dass die vorhandenen Schaltungen aus der applikativen Impedanzmessung der kapazitiven Sensoren für den Selbsttest verwendet werden können. Dieser integrierte Selbsttests wird als "BIST" bezeichnet. Zwischenzeitlich wird diese Bezeichnung auch von den Fachleuten verwendet. Der Begriff steht für "Built-In Self-Test". Diese BIST-Messung hat den Vorteil, dass keine zusätzlichen Spannungskomparatoren, Messeinrichtungen oder Schalter benötigt werden. Somit ist der BIST-Test sehr einfach und kostengünstig durchzuführen. Zudem ist er sehr robust, da keine zusätzlichen Bauelemente fehleranfällig sein können. Die BIST-Messung erfolgt mit DC-Spannungen, die anstelle des AC-Signals, beispielsweise des Sinussignals, von dem Sensor-Treiber ausgegeben werden. Der Strom wird mit Hilfe des gleichen Signalpfads gemessen, der auch für die Impedanzmessung verwendet wird.

Mittels der BIST-Messung können nicht nur die Schalter der Schaltmatrix, sondern auch deren Widerstände überprüft werden. Daneben ist es jedoch auch möglich, einzelnen Fehlermodi der äußeren Beschaltung zu detektieren. Beispielsweise lassen sich Kurzschlüsse von Kapazitäten erkennen, die mit dem Sensor-Port verbunden sind. Kurzgeschlossene Kapazitäten haben einen erhöhten DC-Strom zur Folge und werden somit erkannt. Auch Leitungsunterbrechungen, beispielsweise in Zuleitungen zwischen der Sensor-Schaltung und den kapazitiven Sensoren können generell erkannt werden.

In einer bevorzugten Ausführungsform ist die Sensor-Schaltung derart ausgebildet, dass sie einen DC-Treibereingang und einen Sensor-Treibereingang aufweist. An dem DC-Treibereingang kann ein DC-Signal in den DC-Referenztreiber eingespeist werden, das dann von dem Treiber ausgegeben wird. An dem Sensor-Treibereingang kann der Sensor-Treiber mittels eines externen Signals versorgt werden, das er ausgibt. An dem Sensor-Treibereingang kann ein Sinussignal oder ein anderes AC-Signal eingespeist werden, das für die applikative Impedanzmessung verwendet wird. Für den BIST-Test kann an dem Sensor-Treibereingang anstelle des AC-Signals ein DC-Signal eingespeist werden, das während des Selbsttests verwendet und ausgegeben wird. Auf diese Weise ist es einfach möglich, dass der Sensor-Treiber in die Lage versetzt wird, sowohl ein AC-Signal bzw. Sinussignal als auch ein DC-Signal auszugeben.

In einer bevorzugten Ausführungsform ist die Sensor-Schaltung dazu ausgebildet, auch eine Schirm-Elektrode eines Sensor-Elements oder eine zu einem kapazitiven Sensor gehörende Schirm-Elektrode zu versorgen und anzusteuern. Die Sensor-Schaltung umfasst bevorzugt einen Schirm-Treiber zum Erzeugen eines Schirm-Sinussignals oder Schirm-AC-Signals, das an einem Schirm-Port ausgegeben wird, an dem eine derartige Schirm-Elektrode anschließbar ist. Bevorzugt ist die Schirm-Elektrode parallel zu dem kapazitiven Sensor geschaltet, sodass eine Messung zum Erhöhen der Sensorgenauigkeit durchführbar ist. Zudem werden Schirm-Elektroden häufig eingesetzt, um parasitäre Kapazitäten und andere parasitäre Effekte bei der Impedanzmessung der Sensoren zu unterdrücken.

Bevorzugt umfasst die Sensor-Schaltung einen Schirm-Switchload-Port, der ebenfalls zum Anschluss an die Schirm-Elektrode vorgesehen ist, und zu jedem Sensor-Port einen zugeordneten Sensor-Switchload-Port zum Anschluss an den Sensor. Zwischen dem Schirm-Switchload-Port und jedem Sensor-Switchload-Port wird ein Switchload-Pfad gebildet, der einen Switchload-Schalter und einen Switchload-Widerstand umfasst. Die Switchload-Pfade können in der Schaltmatrix der Sensor-Schaltung integriert sein. Über die Switchload-Pfade ist jeder Sensor-Switchload-Port mit einem zugehörigen Schirm-Switchload-Port verbunden. Der Switchload-Widerstand kann durch einen oder mehrere in Reihe angeordnete Widerstände gebildet sein. In der Praxis hat sich ein Wert von 2,5 kOhm als vorteilhaft erwiesen.

In einer bevorzugten Ausführungsform der Sensor-Schaltung ist vorgesehen, dass jeder Switchload-Pfad in einem Selbsttest überprüfbar ist. Der Schirm-Treiber ist bevorzugt dazu ausgebildet, ein Schirm-DC-Signal auszugeben, welches während des Selbsttests verwendet wird. Das Schirm-DC-Signal ist bevorzugt ungleich zu dem DC-Signal des Sensor-Treibers, besonders bevorzugt ist es kleiner als das DC-Signal des Sensor-Treibers. Auf diese Weise wird eine Spannungsdifferenz zwischen den beiden Treibern gebildet, so dass während des Selbsttests ein Strom durch den Switchload-Pfad getrieben wird und der Switchload-Widerstand und der Switchload-Schalter überprüft werden können. Dazu wird ein Schirm-Überprüfungspfad gebildet, indem der Sensor-Schalter geschlossen wird und eine Verbindung zwischen dem Schirm-Port und dem Schirm-Switchload-Port hergestellt wird sowie eine Verbindung zwischen dem Sensor-Port und dem Sensor-Switchload-Port. Zur Überprüfung wird zum einen der Switchload-Schalter geschlossen, um den Switchload-Widerstand zu überprüfen. Der von dem Sensor-Treiber eingespeiste Messstrom am Stromausgangsport wird gemessen. Ein Vergleich des Stroms mit einem Grenzwert erlaubt eine Aussage über die Fehlerfreiheit des Switchload-Widerstands.

Beim Öffnen des Switchload-Schalters muss der gemessene Stromwert nahe oder gleich Null sein. Auf diese Weise lässt sich mittels der beiden Messungen mit geschlossenem und geöffnetem Switchload-Schalter auch die Fehlerfreiheit des Switchload-Schalters zuverlässig überprüfen.

In einer bevorzugten Ausbildungsform des Messsystems ist die Sensor-Schaltung dazu ausgebildet, einen Selbsttest für alle Sensor-Ports durchzuführen, bevorzugt einen Selbsttest für alle Sensor-Ports nacheinander durchzuführen. In einer besonders bevorzugten Ausführungsform wird nach jeder Messung der Impedanz des kapazitiven Sensors ein Selbsttest für den entsprechenden Sensor-Port durchgeführt.

Vorzugsweise weist die Sensor-Schaltung des Messsystems mehrere Sensor-Ports auf, bevorzugt wenigstens vier, besonders bevorzugt wenigstens acht. Auf diese Weise lassen sich mehrere kapazitive Sensoren an die Sensor-Schaltung anschließen und mittels eines Selbsttests überprüfen.

In einer weiter bevorzugten Ausführungsform ist zwischen der Sensor-Schaltung und den Sensoren ein Filternetzwerk angeordnet, das bevorzugt für jeden kapazitiven Sensor einen Filter vorsieht. In einer bevorzugten Ausführungsform ist zwischen jedem Sensor und jedem Sensor-Port der Sensor-Schaltung ein Filter angeordnet, der einen Kopplungskondensator umfasst, welcher bevorzugt die DC-Kopplung bildet. Besonders bevorzugt ist der Filter als EMV-Filter (Elektromagnetische Verträglichkeit-Filter) ausgebildet, der eine serielle Induktivität und eine weitere parallele Kapazität umfasst.

In einer ebenfalls bevorzugten Ausführungsform umfasst das Messsystem eine Schirm-Elektrode, die bevorzugt parallel zu dem Sensor geschaltet sein kann. Besonders bevorzugt wird aus der Schirm-Elektrode und dem kapazitiven Sensor ein Sensor-Element gebildet. Ebenfalls bevorzugt ist ein Sensor-Element, das eine Schirm-Elektrode und mehrere kapazitive Sensoren umfasst.

Vorzugsweise hat die Sensor-Schaltung des Messsystems einen Schirm-Treiber zum Erzeugen eines Schirm-AC-Signals oder eines Schirm-Sinussignals, das an einem Schirm-Port der Sensor-Schaltung ausgegeben wird, an dem die Schirm-Elektrode angeschlossen ist. Auf diese Weise lässt sich die Sensorgenauigkeit erhöhen, beispielsweise können parasitäre Kapazitäten und deren Einfluss verhindert werden.

In einer bevorzugten Ausführungsform umfasst die Sensor-Schaltung des Messsystems zwei Switchload-Ports, die über einen Switchload-Pfad mit einem Switchload-Schalter und einem Switchload-Widerstand miteinander verbunden sind. Der eine Switchload-Port ist ein Schirm-Switchload-Port zum Anschluss an die Schirm-Elektrode. Der zweite Switchload-Port ist ein Sensor-Switchload-Port zum Anschluss an den Sensor. Sind in der Sensor-Schaltung mehrere Sensor-Ports vorhanden, so umfasst die Sensor-Schaltung bevorzugt zu jedem Sensor-Port einen korrespondierenden Sensor-Switchload-Port, der diesem Sensor-Port zugeordnet ist. Besonders bevorzugt ist der Sensor-Port mit dem zugeordneten Sensor-Switchload-Port verbunden. Eine derartige Verbindung kann beispielsweise auch in einem zwischen Sensor-Schaltung und Sensor angeordnetem Filter gebildet werden.

Eine bevorzugte Ausführungsform des Messsystems umfasst eine Auswerteeinheit, die bevorzugt Teil der Sensor-Schaltung sein kann. Besonders bevorzugt weist die Auswerteeinheit eine analoge Signalverarbeitungseinheit auf und gibt ein Messsignal für eine AD-Wandlung aus, beispielsweise an einen AD-Wandler. Bevorzugt umfasst die Auswerteeinheit auch einen Verstärker und/oder einen Filter, um das Messsignal für die AD-Wandlung entsprechend aufzubereiten.

Die Erfindung wird nachfolgend anhand einiger ausgewählter Ausführungsbeispiele im Zusammenhang mit den beiliegenden Zeichnungen näher beschrieben und erläutert. Es zeigen:
- Figur 1: eine erfindungsgemäße Sensorschaltung mit einem Sensor-Element und mehreren Sensoren;
- Figur 2: ein erfindungsgemäßes Messsystem mit einer Sensor-Schaltung aus Figur 2;
- Figur 3: eine alternative Ausführungsform der Sensor-Schaltung aus Figur 1;
- Figur 4: eine Prinzipschaltung einer weiteren Ausführungsform der Sensor-Schaltung mit Sensor;
- Figur 5: ein prinzipielles Blockdiagramm einer Realisierung der Sensor-Schaltung auf einem IC;
- Figur 6: den prinzipiellen Ablauf eines Verfahrens zum integrierten Selbsttest einer Sensor-Schaltung gemäß Figur 1; und
- Figur 7: ein Verfahren zum integrierten Selbsttest von sicherheitsrelevanten Komponenten einer Sensor-Schaltung gemäß Figur 3.

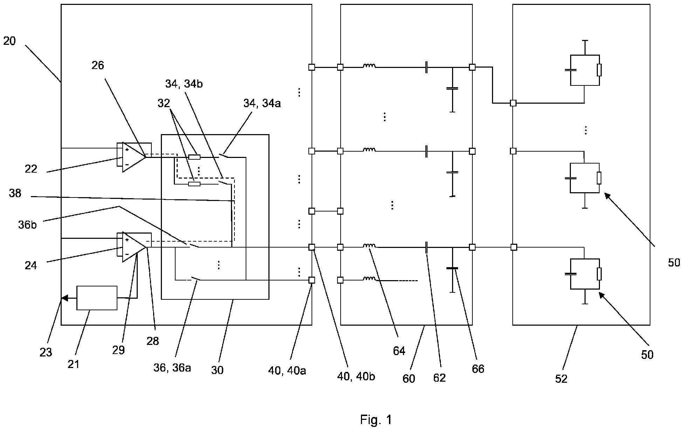

Figur 1 zeigt eine Sensor-Schaltung 20, die einen DC-Referenztreiber 22 und einen Sensor-Treiber 24 umfasst. Die Sensor-Schaltung 20 umfasst eine Schaltmatrix 30, die zwischen den beiden Treibern und einzelnen Sensor-Ports 40 angeordnet ist, an denen einzelne Sensoren 50 angeschlossen werden können. Ein DC-Treiberausgang 26 kann durch interne Leitungspfade der Schaltmatrix 30 mit jedem der Sensor-Ports 40 verbunden werden. Gleiches gilt für einen Ausgangsport 28 des Sensor-Treibers 24, der auf jeden der Sensor-Ports 40 geschaltet werden kann.

Der Sensor-Treiber 24 hat einen Stromausgangsport 29, an dem ein Messstrom gemessen wird, der mit dem Signal am Ausgangsport 28 korrespondiert, beispielsweise eine Kopie des Signals ist. An dem Stromausgangsport 29 kann eine optionale Auswerteeinheit 21 angeschlossen sein, die eine analoge Signalverarbeitungseinheit oder ein analoger Signalprozessor (ASP) sein kann, sodass an einem Messausgang 23 ein Signal zur Verfügung steht, was mit einem AD-Wandler verarbeitet werden kann.

Die Schaltmatrix 30 umfasst mehrere Schalter und Lastwiderstände 32, um die Treiberausgänge mit den einzelnen Sensor-Ports 40 zu verschalten. Der DC-Treiberausgang 26 kann über einen Lastwiderstand 32 und einen in Reihe geschalteten RT-Schalter 34 mit dem Sensor-Port 40 verschaltet werden. Ein von dem DC-Referenztreiber 22 ausgegebenes DC-Referenzsignal liegt am Sensor-Port 40 an, wenn der RT-Schalter 34a geschlossen ist. Der Sensor-Port 40a wird also auf ein Gleichspannungspotential gehoben. Gleichzeitig wird der Sensor-Schalter 36a geöffnet, sodass keine Verbindung zum Sensor-Treiber 24 besteht.

Soll an dem Sensor-Port 40b ein angeschlossener Sensor gemessen werden, so wird der entsprechende Sensor-Schalter 36b geschlossen, während gleichzeitig der RT-Schalter 34b geöffnet wird. Somit wird ein von dem Sensor-Treiber 24 am Ausgangsport 28 ausgegebenes AC-Signal an den Sensor-Port 40b weitergeleitet, sodass eine Messung mit einem kapazitiven Sensor 50 erfolgen kann.

Die Sensor-Schaltung 20 kann eine DC-Entkopplung 62 umfassen, die beispielsweise mittels des RT-Schalters 34 in den entsprechenden Pfad geschaltet werden kann, wenn der angeschlossene Sensor-Port 40 nicht mit einem DC-Signal versorgt werden soll. Bevorzugt ist eine DC-Entkopplung 62 in einem Filter 60 angeordnet, wobei der Filter 60 zwischen einem Sensor-Element 52 mit mehreren kapazitiven Sensoren 50 und der Sensor-Schaltung 20 angeordnet ist. Eine Verbindung zwischen Sensor-Schaltung 20 und Sensor 50 erfolgt über den Filter 60. Die DC-Entkopplung 62 kann beispielsweise durch eine in der Zuleitung zu dem Sensor 50 angeordneten seriellen Kapazität gebildet werden. Der hier gezeigte Filter 60 umfasst zusätzlich eine serielle Induktivität 64 am Filtereingang sowie eine EMV-Kapazität 66, die gegen Ground (GND) geschaltet ist. Auf diese Weise werden unerwünschte Störsignale entkoppelt.

Nachdem eine Messung an dem Sensor 50 erfolgt ist, der an einem der Sensor-Ports 40 angeschlossen ist, beispielsweise am Sensor-Port 40b, wie in Figur 1 gezeigt, wird der Sensor-Port 40b von dem Sensor-Treiber 24 entkoppelt, indem der Sensor-Schalter 36b geöffnet wird. Anschließend wird der RT-Schalter 34b geschlossen, sodass der Sensor-Port 40b wieder auf dem Gleichspannungspotential des DC-Referenztreibers 22 liegt. Die DC-Entkopplung 62 verhindert, dass ein Gleichspannungssignal an den Sensor 50 übermittelt wird. Anschließend werden bevorzugt nacheinander alle anderen Sensor-Ports 40 angesteuert, sodass eine Messung mit den entsprechenden Sensoren 50 erfolgen kann. Die RT-Schalter 34 und Sensor-Schalter 36 werden entsprechend geschaltet.

Nach jedem Messzyklus erfiogt bevorzugt ein Selbsttest, der für jeden einzelnen Sensor-Port 40 durchgeführt wird. In Figur 1 ist eine Überprüfung des Sensor-Ports 40b gezeigt. Hierzu wird ein Schaltpfad 38 (gestrichelte Linie) in der Schaltmatrix 30 gebildet. Der RT-Schalter 34b und der Sensor-Schalter 36b werden beide geschlossen. Mittels des Sensor-Treibers 24 wird (anstelle des AC-Signals) ein DC-Signal erzeugt, das bevorzugt größer ist als das DC-Referenzsignal des DC-Referenztreibers 22. Aufgrund der Spannungsdifferenz zwischen den beiden Treibern fließt ein Strom über den Lastwiderstand 32b, der ebenfalls am Stromausgangsport 29 ausgegeben wird und mithilfe der analogen Signalverarbeitung in der Auswerteeinheit 21 gefiltert, verstärkt und mit einem an Messausgang 23 angeordneten Analog-Digital-Wandler digitalisiert werden kann. Außer dem Sensor-Port 40b sind alle anderen Sensor-Ports 40 unbeschaltet, da die entsprechenden RT-Schalter 34 und Sensor-Schalter 36 geöffnet sind.

Während des Selbsttests (BIST) werden für jeden Sensor-Port 40 die zugehörigen RT-Schalter 34 und Sensor-Schalter 36 sowie der Lastwiderstand 32, der bevorzugt 500 Ohm ist, geprüft. Es werden zunächst beide Schalter 34, 36 gleichzeitig geschlossen. Die Ausgangsspannung des Sensor-Treibers 24 wird bevorzugt auf eine maximale Spannung eingestellt, beispielsweise auf 1,9 V. Die Ausgangsspannung liegt damit um 0,5 V über der Ausgangsspannung des DC-Referenztreibers 22, die bevorzugt 1,4 V beträgt. Der von dem Sensor-Treiber 24 gelieferte Strom wird als Messstrom am Stromausgangsport 29 ausgegeben und in der Auswerteeinheit 21 verstärkt, wobei eventuell vorhandene Hochpassfilter während der BIST-Ausführung überbrückt werden, um ein DC-Signal messen zu können. Der digitalisierte Stromwert wird mit Grenzwerten verglichen, die während eines Produktionstests ermittelt werden und in einem Speicher gespeichert werden können. Bevorzugt muss der Messwert zwischen den beiden Grenzen aus dem Produktionstest liegen.

Die Selbsttestmessung für den einzelnen Sensor-Port 40 wird zweimal wiederholt, wobei jeweils einer der beiden Schalter, RT-Schalter 34 bzw. Sensor-Schalter 36, geöffnet wird. Der Strom muss für diese beiden Messungen nahe Null sein. Es kann daher überprüft werden, ob der digitalisierte Messwert, der am Stromausgangsport 29 abgegriffen wird, kleiner als der untere Grenzwert ist.

Mit dieser Schaltung lässt sich also die Funktion aller RT-Schalter 34 und Sensor-Schalter 36 überprüfen. Gleichzeitig kann auch die Größe des Lastwiderstands 32 geprüft werden.

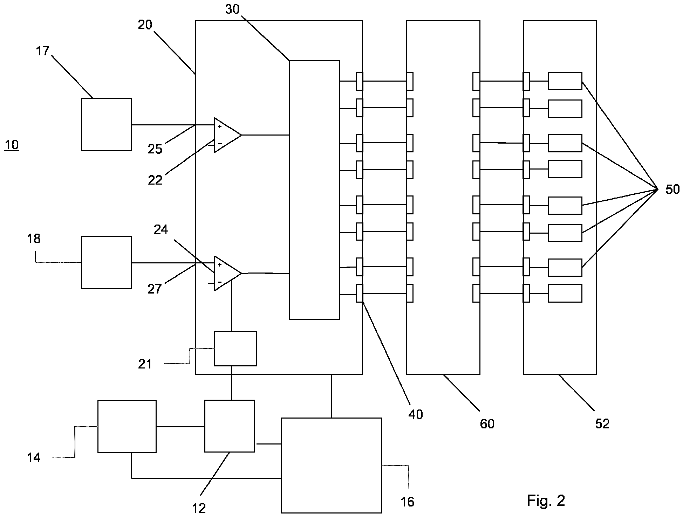

Figur 2 zeigt ein Messystem 10 mit der Sensor-Schaltung 20, einem Sensor-Element 52 mit mehreren Sensoren 50 und einem zwischen Sensor-Element 52 und Sensor-Schaltung 20 geschalteten Filter 60. In der hier gezeigten Ausführungsform hat die Sensor-Schaltung 20 acht Sensor-Ports 40, sodass die acht Sensoren 50 des Sensor-Elements 52 gemessen werden können. Die Sensor-Schaltung 20 umfasst die Schaltmatrix 30, um die Ausgänge des DC-Referenztreibers 22 und des Sensor-Treibers 24 mit den einzelnen Sensor-Ports 40 verschalten zu können. An dem Stromausgangsport 29 ist die Auswerteeinheit 21 angeschlossen, deren Ausgangssignal an einen AD-Wandler 12 ausgegeben wird. Der AD-Wandler 12 kann eine Vergleichereinheit umfassen, um Grenzwerte, die beispielsweise in einer Speichereinheit 14 hinterlegt sind, gegen die digitalisierten Strommesswerte zu prüfen. Eine Verarbeitungseinheit 16 kann die Vergleiche zwischen dem digitalisierten Stromwert und den Grenzwerten vornehmen und ein entsprechendes Evaluierungssignal erzeugen oder ein Fehlersignal ausgeben. Darüber hinaus kann die Verarbeitungseinheit 16 die Sensor-Schaltung 20 steuern und die entsprechenden Schalter öffnen oder schließen.

In der hier gezeigten Ausführungsform des Messsystems 10 ist eine DC-Quelle 17 an einem DC-Treibereingang 25 angeordnet, die ein DC-Signal erzeugt und damit den DC-Referenztreiber 22 speist. An einem Sensor-Treibereingang 27 des Sensor-Treibers 24 ist eine Signalquelle 18 angeordnet, die ein AC-Signal und alternativ ein DC-Signal ausgeben kann. Somit lässt sich der Sensor-Treiber 24 sowohl mit einem AC-Signal, beispielsweise einem Sinussignal, oder einem DC-Signal speisen. Letzteres wird für den Selbsttest verwendet.

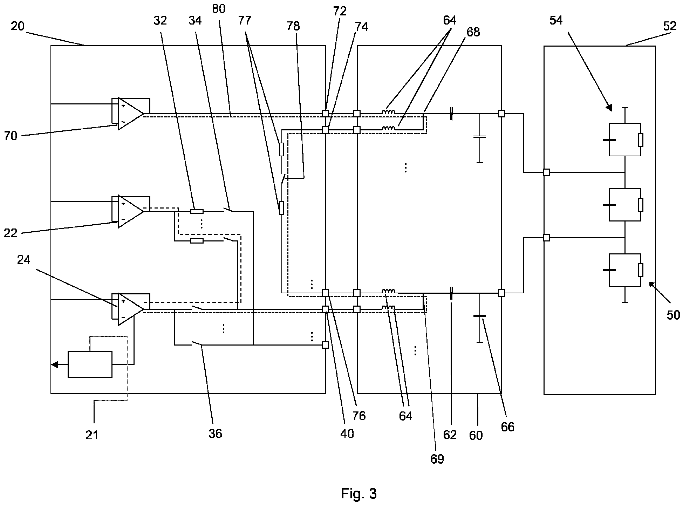

Figur 3 zeigt eine alternative Ausführungsform der Sensor-Schaltung 20, die zusätzlich einen Schirm-Treiber 70 umfasst, der an eine Schirm-Elektrode 54 des Sensor-Elements 52 angeschlossen ist. Schirm-Elektrode 54 und Sensor 50 sind jeweils als RC-Netzwerk dargestellt. Die Beziehung zwischen der Schirm-Elektrode 54 und dem Sensor 50 kann ebenfalls mittels eines RC-Netzwerks repräsentiert werden, wie in Figur 3 gezeigt.

Der Schirm-Treiber 70 erzeugt während der Messung ein Schirm-AC-Signal, das über einen Schirm-Port 72 und über den Filter 60 an die Schirm-Elektrode 54 ausgegeben wird. In dem Filter 60 ist hinter der Induktivität 64 ein Knotenpunkt 68 angeordnet, von dem eine Leitung mit weiterer serieller Induktivität 64 zu einem Schirm-Switchload-Port 74 der Sensor-Schaltung 20 führt.

Jedem Sensor-Port 40 ist ein Sensor-Switchload-Port 76 zugeordnet, der in dem Filter 60 an einem weiteren Knotenpunkt 69 mit dem Sensor-Port 40 verbunden ist. Zwischen dem Schirm-Switchload-Port 74 und dem jeweiligen Sensor-Switchload-Port 76 ist eine schaltbare Verbindung mit einem Switchload-Widerstand 77, der in der hier gezeigten Ausführungsform aus zwei Einzelwiderständen besteht, und einem in Reihe geschalteten Switchload-Schalter 78. Durch entsprechende Verschaltung und unterschiedliche Schaltzustände der Switchload-Schalter 78, RT-Schalter 34 und Sensor-Schalter 36 können unterschiedliche Messungen vorgenommen werden. In dem hier gezeigten Beispiel eines kapazitiven Sitzbelegungssensors lässt sich durch geeignete Verschaltung nicht nur die prinzipielle Belegung des Sitzes erkennen, sondern auch eine qualitative Kraftmessung durchführen.

Somit sind auch die Switchload-Schalter 78 und die Switchload-Widerstände 77 sicherheitsrelevante Bauteile, deren Funktionsfähigkeit mittels BIST überprüft werden muss. In analoger Weise, wie bei der Überprüfung der Sensor-Schalter 36 und RT-Schalter 34, wird der Schirm-Treiber 70 mit einem DC-Signal gespeist, sodass ein DC-Signal an seinem Ausgang ausgegeben wird. Zwischen dem Schirm-Treiber 70 und dem Sensor-Treiber 24, die beide mit Gleichstrom betrieben werden, wird eine Spannungsdifferenz gebildet, die zu einem Strom durch den Switchload-Pfad 80 führt, der als gestrichelte Linie dargestellt ist. Durch Öffnen und Schließen des Switchload-Schalters 78 und des Sensor-Schalters 36 können für jeden Sensor-Port 40 die Funktionsfähigkeit des Switchload-Pfads 80 und die damit eingeschlossenen Komponenten geprüft werden. Es lassen sich somit ebenso Leitungsunterbrechungen in dem Switchload-Pfad 80 erkennen wie defekte Induktivitäten 64 in dem Pfad.

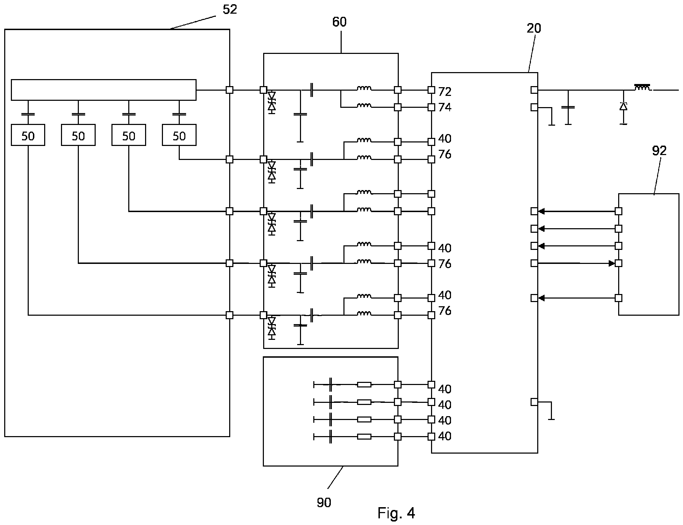

Figur 4 zeigt eine besondere Ausführungsform einer Sensor-Schaltung 20, die als Sensor-IC ausgebildet ist. Die Sensor-Schaltung 20 hat insgesamt acht Sensor-Ports 40, wobei vier der Sensor-Ports 40 an ein Referenzelement 90 mit vier Eingängen angeschlossen sind. Zu den vier weiteren Sensor-Ports 40 gibt es korrespondierende Sensor-Switchload-Ports 76, die über einen Filter 60 an ein Sensor-Element 52 mit vier Sensoren 50 angeschlossen sind. Das Sensor-Element umfasst weiter eine Schirm-Elektrode 54, die über den Filter 60 mit einem Schirm-Port 72 verbunden ist. Der Schirm-Switchload-Port 74 ist intern mit den Sensor-Switchload-Ports 76 verbunden, wie in Figur 3 dargestellt. Ein Host-Microcontroller 92, der mit der Sensor-Schaltung 20 verbunden ist, ist für die Ansteuerung der Sensor-Schaltung 20 verantwortlich und liefert die notwendigen Signale und empfängt die Ergebnisse der Messung bzw. einen aufbereiteten Messstrom des Sensor-Treibers 24.

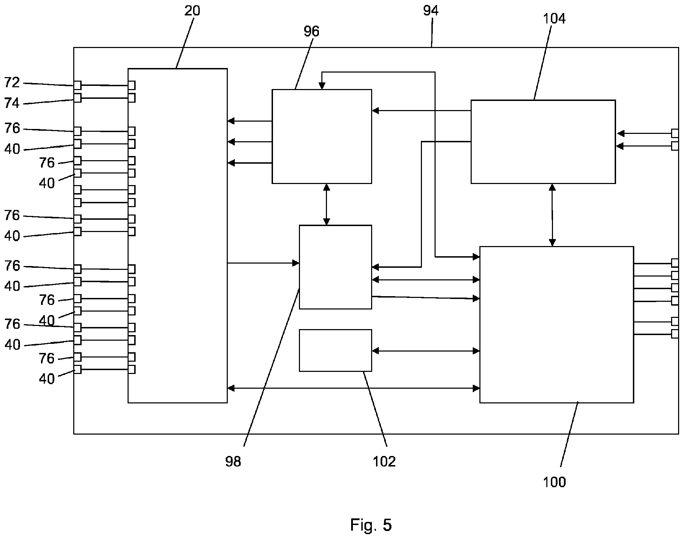

Figur 5 zeigt eine Implementierung eines integrierten Bausteins, IC-Baustein 94 mit Sensor-Schaltung 20, an der acht kapazitive Sensoren 50 und eine Schirm-Elektrode 54 angeschlossen werden können. Die entsprechenden Sensor-Ports 40, die Sensor-Switchload-Ports 76, Schirm-Port 72 und Schirm-Switchload-Port 74 sind an der linken Seite angeschlossen. Der IC-Baustein 94 umfasst weiter einen Signalquellenbaustein 96, der die AC-Signale, etwa ein Sinussignal, und die DC-Signale für die entsprechenden Treiber der Sensor-Schaltung 20 zur Verfügung stellt. Ein analoger Signalprozessor 98 verarbeitet das Messsignal, das am Stromausgangsport 29 des Sensor-Treibers 24 ausgegeben wird, weiter und stellt es einer Steuereinheit 100 zur Verfügung, die von einem Clock-Generator 102 gespeist wird. Die einzelnen Bausteine werden über einen Spannungsversorgungsbaustein 104 gespeist. Andere Implementierungen eines IC-Bausteins sind möglich. Der hier gezeigte IC stellt jedoch eine sehr kompakte Bauform dar.

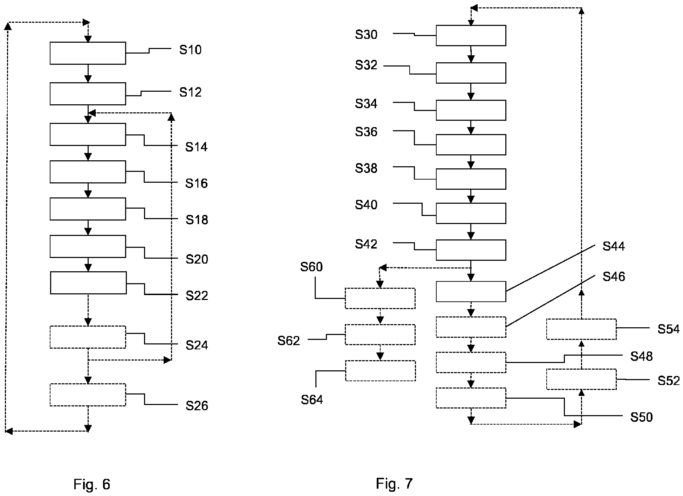

Figur 6 zeigt den prinzipiellen Ablauf eines Verfahrens zum integrierten Selbsttest von sicherheitsrelevanten Komponenten einer Sensor-Schaltung für kapazitive Sensoren. Die entsprechenden Ausführungsformen einer Sensor-Schaltung sind oben beschrieben. Das Verfahren umfasst die folgenden Schritte:

In einem ersten Schritt S10 erfolgt das Schließen des RT-Schalters 34 und des Sensor-Schalters 36 eines Schaltpfads 38 der Schaltmatrix 30 für einen ausgewählten Sensor-Port 40. In einem weiteren Schritt S12 des Verfahrens erfolgt das Öffnen der RT-Schalter 34 und Sensor-Schalter 36 der anderen Schaltpfade 38 der Schaltmatrix 30. Ein Schritt S14 des Ausgebens eines DC-Referenzsignal an dem DC-Referenztreiber 22 wird gefolgt von einem Schritt S18 des Ausgebens eines DC-Signals an dem Sensor-Treiber 24, wobei sich das DC-Signal von dem DC-Referenzsignal unterscheidet, bevorzugt größer ist. Ein Schritt S20 betrifft das Messen des an dem Stromausgangsport 29 des Sensor-Treibers 24 zur Verfügung gestellten Messstroms. In einem Schritt S22 wird der Messstrom mit einem Grenzwert verglichen.

In einem optionalen Schritt S24 werden der RT-Schalter 34 und/oder der Sensor-Schalter 36 des ausgewählten Schaltpfads 38 geöffnet. Die Schritte S14 bis S22 werden für jede Schalterstellung wiederholt, wobei bevorzugt lediglich einer der beiden Schalter 34, 36 geöffnet ist. Diese optionalen Schritte sind gestrichelt in Figur 6 dargestellt.

Eine weiter bevorzugte Ausführungsform des Verfahrens umfasst in einem Schritt S26 das Öffnen der beiden Schalter des ausgewählten Schaltpfads 38 der Schaltmatrix 30. In einem nächsten Schritt wird ein weiterer Schaltpfad ausgewählt und das Verfahren beginnt mit Schritt S10 erneut. Dabei wird das Verfahren für alle Sensor-Ports 40 der Sensor-Schaltung 20 durchgeführt.

Figur 7 zeigt eine besondere Ausführungsform eines Selbsttestverfahrens, das sich an das Verfahren gemäß Figur 6 anschließen kann. Das Verfahren gemäß Figur 7 erfolgt, wenn eine Schirm-Elektrode in einem Sensor-Element mit mehreren Sensoren verwendet wird. In einem Schritt S30 werden alle RT-Schalter 34 und Sensor-Schalter 38 aller Schaltpfade 36 für die Sensor-Ports 40 geöffnet. Das Auswählen eines Sensor-Ports 40 zur Überprüfung des zugehörigen Sensor-Switchload-Ports 76 erfolgt in Schritt S32. Darin schließt sich Schritt S34 an, der das Öffnen der Switchload-Schalter 78 aller anderen Switchload-Pfade 80 umfasst. Für den ausgewählten Sensor-Port 40 erfolgt in Schritt S36 das Schließen des entsprechenden Sensor-Schalters 36. Schritt S38 sieht das Ausgeben eines DC-Schirm-Signals an dem Schirm-Treiber 70 vor. In einem Schritt S40 wird ein DC-Signal an dem Sensor-Treiber 24 ausgegeben, dass sich von dem DC-Schirm-Signal unterscheidet, bevorzugt größer ist. Ein Schritt S42 umfasst das Messen des an dem Stromausgangsport 29 des Sensor-Treibers 24 zur Verfügung gestellten Messstroms. Ein Schritt S44 des Vergleichens des Messstroms mit einem Grenzwert schließt sich an.

In einer optionalen Ausführungsform werden weitere optionale Schritte des Verfahrens durchgeführt. Ein Schritt S46 betrifft das Öffnen des Switchload-Schalters 78 des ausgewählten Switchload-Pfads 80. Ein Schritt S48 betrifft das Messen des an dem Stromausgangsport des Sensor-Treibers 22 zur Verfügung gestellten Messstroms. Dieser Schritt wird von einem Schritt S50 gefolgt, der das Vergleichen des Messstroms mit einem Grenzwert vorsieht.

Optional kann das Verfahren weitere Schritte umfassen. In einem Schritt S52 werden der Switchload-Schalter 78 und der Sensor-Schalter 36 für den ausgewählten Sensor-Port 40 geöffnet. Ein Schritt S54 umfasst das Auswählen eines weiteren Switchload-Pfads 80 der Sensor-Schaltung 20. Hieran schließen sich optional die anderen Schritte des Verfahrens gemäß Figur 7 an.

Eine weitere ebenfalls bevorzugte Ausführungsform des Verfahrens sieht in einem Schritt S60 vor, dass der Messstrom vor dem Vergleich mit dem Grenzwert digitalisiert wird. In einem Schritt S62 wird geprüft, ob der digitale Wert des Messstroms den jeweiligen Grenzwert oder die jeweiligen Grenzwerte einhalten. Ein Schritt S64 betrifft das Ausgeben eines Validierungssignals an eine Ausgabeeinheit.

Die Erfindung wurde anhand der Zeichnungen und der Beschreibung umfassend beschrieben und erklärt. Die Beschreibung und Erklärung sind als Beispiel und nicht einschränkend zu verstehen. Die Erfindung ist nicht auf die offenbarten Ausführungsformen beschränkt. Andere Ausführungsformen oder Variationen ergeben sich für den Fachmann bei der Verwendung der vorliegenden Erfindung sowie bei einer genauen Analyse der Zeichnungen, der Offenbarung und der nachfolgenden Patentansprüche.

In den Patentansprüchen schließen die Wörter "umfassen" und "mit" nicht das Vorhandensein weiterer Elemente oder Schritte aus. Der undefinierte Artikel "ein" oder "eine" schließt nicht das Vorhandensein einer Mehrzahl aus. Ein einzelnes Element oder eine einzelne Einheit kann die Funktionen mehrerer der in den Patentansprüchen genannten Einheiten ausführen. Ein Element, eine Einheit, eine Vorrichtung und ein System können teilweise oder vollständig in Hard- und/oder in Software umgesetzt sein. Die bloße Nennung einiger Maßnahmen in mehreren verschiedenen abhängigen Patentansprüchen ist nicht dahingehend zu verstehen, dass eine Kombination dieser Maßnahmen nicht ebenfalls vorteilhaft verwendet werden kann. Ein Computerprogramm kann auf einem nichtflüchtigen Datenträger gespeichert/vertrieben werden. Ein Computerprogramm kann zusammen mit Hardware und/oder als Teil einer Hardware vertrieben werden, beispielsweise mittels des Internets oder mittels drahtgebundener oder drahtloser Kommunikationssysteme. Bezugszeichen in den Patentansprüchen sind nicht einschränkend zu verstehen.

### Bezugszeichen

- 10: Messsystem
- 12: AD-Wandler
- 14: Speichereinheit
- 16: Verarbeitungseinheit
- 17: DC-Quelle
- 18: Signalquelle
- 20: Sensor-Schaltung
- 21: Auswerteeinheit
- 22: DC-Referenztreiber
- 23: Messausgang
- 24: Sensor-Treiber
- 25: DC-Treibereingang
- 26: DC-Treiberausgang
- 27: Sensor-Treibereingang
- 28: Ausgangsport
- 29: Stromausgangsport
- 30: Schaltmatrix
- 32: Lastwiderstand
- 34: RT-Schalter
- 36: Sensor-Schalter
- 38: Schaltpfad
- 40: Sensor-Port
- 50: Sensor
- 52: Sensor-Element
- 54: Schirm-Elektrode
- 60: Filter
- 62: DC-Entkopplung
- 64: Induktivität
- 66: EMV-Kapazität
- 68: Knotenpunkt
- 69: Knotenpunkt
- 70: Schirm-Treiber
- 72: Schirm-Port
- 74: Schirm-Switchload-Port
- 76: Sensor-Switchload-Port
- 77: Switchload-Widerstand
- 78: Switchload-Schalter
- 80: Switchload-Pfad
- 90: Referenzelement
- 92: Host Microcontroller
- 94: IC-Baustein
- 96: Signalquellenbaustein
- 98: analoger Signalprozessor
- 100: Steuereinheit
- 102: Clock-Generator
- 104: Spannungsversorgungsbaustein

## Patentansprüche

1. Sensor-Schaltung für kapazitive Sensoren (50) umfassend
einen DC-Referenztreiber (22) zum Erzeugen eines DC-Referenzsignals,
einen Sensor-Treiber (24) zum Erzeugen eines AC-Signals, mit einem Ausgangsport (28), um das AC-Signal zum Speisen der kapazitiven Sensoren (50) auszugeben, und mit einem Stromausgangsport (29), um einen zu dem am Ausgangsport ausgegebenen AC-Signal korrespondierenden Messstrom auszugeben,
mehrere Sensor-Ports (40) zum Anschluss an je einen kapazitiven Sensor (50),
eine Schaltmatrix (30) zum Herstellen einer Verbindung der Sensor-Ports (40) mit den Treibern, wobei die Schaltmatrix (30) für jeden Sensor-Port (40) einen Schaltpfad mit einem RT-Schalter (34), einem Sensor-Schalter (36) und einem Lastwiderstand (32) aufweist, und
eine DC-Entkopplung (62) zwischen Schaltmatrix (30) und kapazitiven Sensor (50), zum DC-Entkoppeln der Schaltmatrix (30) von den kapazitiven Sensoren (50),
wobei die Sensor-Schaltung (20) dazu ausgebildet ist, einen Selbsttest durchzuführen, bei dem
- der Sensor-Treiber (24) ein DC-Signal ausgibt, so dass eine Spannungsdifferenz zwischen dem DC- Referenztreiber (22) und dem Sensor-Treiber (24) gebildet wird, die über der Schaltmatrix (30) anliegt, und
- der während des Selbsttests über die Schaltmatrix (30) fließende Strom gemessen wird.

2. Sensor-Schaltung nach Anspruch 1, **dadurch gekennzeichnet, dass** während des Selbsttest die Schaltmatrix (30) derart geschaltet wird, dass die einzelnen Sensor-Ports (40) abwechseln angesteuert werden und bevorzugt die anderen Sensor-Ports (40) auf einem definierten Potential liegen oder besonders bevorzugt von der Schaltmatrix (30) entkoppelt sind.

3. Sensor-Schaltung nach Anspruch 1 oder 2, **dadurch gekennzeichnet, dass** während des Selbsttests der RT-Schalter (34) und/oder der Sensor-Schalter (36) eines Schaltpfads in verschiedene Schaltstellungen geschaltet werden.

4. Sensor-Schaltung nach einem der vorhergehenden Ansprüche, **dadurch gekennzeichnet, dass** die Sensor-Schaltung (20) einen DC-Treibereingang (25) und einen Sensor-Treibereingang (27) aufweist, um den DC-Referenztreiber (22) mit einem DC-Signal zu speisen und den Sensor-Treiber (24) mit einem AC-Signal und/oder mit einem DC-Signal zu speisen, wobei bevorzugt während des Selbsttests der Sensor-Treiber (24) mit einem DC-Signal gespeist wird und dieses ausgibt.

5. Sensor-Schaltung nach einem der vorhergehenden Ansprüche, **dadurch gekennzeichnet, dass** die Sensor-Schaltung (20) einen Schirm-Treiber (70) zum Erzeugen eines Schirm-AC-Signals umfasst, das an einen Schirm-Port (72) ausgegeben wird, an dem eine Schirm-Elektrode (54) anschließbar ist, die bevorzugt parallel zu dem kapazitiven Sensor (50) geschaltet ist, so dass eine Messung zum Erhöhen der Sensorgenauigkeit durchführbar ist.

6. Sensor-Schaltung nach dem vorhergehenden Anspruch, **dadurch gekennzeichnet, dass** die Sensor-Schaltung (20) einen Schirm-Switchload-Port (74) zum Anschluss an die Schirm-Elektrode (54) und zu jedem Sensor-Port (40) einen zugeordneten Sensor-Switchload-Port (76) zum Anschluss an den Sensor (50) umfasst, wobei zwischen dem Schirm-Switchload-Port und jedem Sensor-Switchload-Port ein Switchload-Pfad (80) mit einem Switchload-Schalter (78) und einem Switchload-Widerstand (77) gebildet wird, sodass jeder Sensor-Switchload-Port und der Schirm-Switchload-Port miteinander verbunden sind.

7. Sensor-Schaltung nach dem vorhergehenden Anspruch, **dadurch gekennzeichnet, dass** jeder Switchload-Pfad (80) in einem Selbsttest überprüfbar ist und wobei in dem Selbsttest der Schirm-Treiber (70) ein Schirm-DC-Signal ausgibt, welches bevorzugt ungleich ist zu dem DC-Signal des Sensor-Treibers (24), besonders bevorzugt kleiner ist als das DC-Signal des Sensor-Treibers (24).

8. Kapazitives Messsystem zum Auswerten eines kapazitiven Sensors, umfassend den Sensor (50) mit einer Sensor-Elektrode, eine Sensor-Schaltung (20) für den kapazitiven Sensor (50) und eine DC-Entkopplung zwischen Sensor-Schaltung (20) und Sensor,
wobei die Sensor-Schaltung (20) umfasst:
einen DC-Referenztreiber (22) zum Erzeugen eines DC-Referenzsignals;
einen Sensor-Treiber (24) zum Erzeugen und Ausgeben eines AC-Signals an einem Ausgangsport zum Speisen des Sensors (50);
einen Sensor-Port (40) zum Anschluss an den Sensor;
eine Schaltmatrix (30) zum Herstellen einer Verbindung des Sensor-Ports (40) mit den beiden Treibern;
wobei
- der Sensor-Treiber (24) einen Stromausgangsport (29) aufweist, um einen zu dem am Ausgangsport (28) ausgegebenen AC-Signal korrespondierenden Messstrom auszugeben;
- die Schaltmatrix (30) einen RT-Schalter (34), einen Sensor-Schalter (36) und einen Lastwiderstand (32) zur Verbindung mit dem Sensor-Port (40) umfasst;
- die Sensor-Schaltung (20) dazu ausgebildet ist, einen Selbsttest durchzuführen, bei dem der Sensor-Treiber (24) ein DC-Signal ausgibt, so dass eine Spannungsdifferenz zwischen dem DC-Referenztreiber (22) und dem Sensor-Treiber (24) gebildet wird, die über der Schaltmatrix (30) anliegt; und
- der während des Selbsttests über die Schaltmatrix (30) fließende Strom gemessen wird.

9. Messsystem nach dem vorhergehenden Anspruch, **dadurch gekennzeichnet, dass** zwischen der Sensor-Schaltung (20) und dem Sensor (50) ein Filternetzwerk angeordnet ist, das bevorzugt einen Kopplungskondensator umfasst, der besonders bevorzugt die DC-Entkopplung ist.

10. Messsystem nach Anspruch 8 oder 9, **dadurch gekennzeichnet, dass** der während des Selbsttests über die Schaltmatrix (30) fließende Strom am Stromausgangsport (29) des Sensor-Treibers (24) gemessen wird.

11. Messsystem nach einem der Ansprüche 8 bis 10, **dadurch gekennzeichnet, dass** das Messsystem eine Schirm-Elektrode aufweist und dass die Sensor-Schaltung (20) einen Schirm-Treiber (70) zum Erzeugen eines Schirm-AC-Signals umfasst, das an einen Schirm-Port (72) ausgegeben wird, an dem die Schirm-Elektrode (54) angeschlossen ist, die bevorzugt parallel zu dem Sensor (50) geschaltet ist, so dass eine Messung zum Erhöhen der Sensorgenauigkeit durchführbar ist.

12. Messsystem nach dem vorhergehenden Anspruch, **dadurch gekennzeichnet, dass** die Sensor-Schaltung (20) zwei Switchload-Ports umfasst sind, die über einen Switchload-Pfad (80) mit einem Switchload-Schalter (78) und einem Switchload-Widerstand (77) mit einander verbunden sind, wobei der eine Switchload-Port ein Schirm-Switchload-Port (74) zum Anschluss an die Schirm-Elektrode (54) ist und der zweite Switchload-Port ein Sensor-Switchload-Port (76) zum Anschluss an den Sensor (50) ist, wobei bevorzugt jedem Sensor-Port (40) ein korrespondierender Sensor-Switchload-Port zugeordnet ist, wobei besonders bevorzugt der Sensor-Port (40) mit dem zugeordneten Sensor-Switchload-Port verbunden ist.

13. Messsystem nach einem der Ansprüche 8 bis 12, **dadurch gekennzeichnet, dass** die Sensor-Schaltung (20) eine Auswerteeinheit (21) umfasst, die bevorzugt eine analoge Signalverarbeitungseinheit ist und ein Messsignal für eine AD-Wandlung ausgibt, wobei bevorzugt die Auswerteeinheit einen Verstärker und/oder einen Filter umfasst.

14. Messsystem nach einem der Ansprüche 8 bis 13, **dadurch gekennzeichnet, dass** zwischen der Sensor-Schaltung (20) und den Sensoren (50) je ein Filter (60) angeordnet ist, der bevorzugt die DC-Kopplung (62) umfasst und weiter bevorzugt ein EMV-Filter ist, der eine serielle Induktivität (64) und eine parallele Kapazität umfasst.

15. Verfahren zum integrierten Selbsttest von sicherheitsrelevanten Komponenten einer Sensor-Schaltung (20) für kapazitive Sensoren (50), wobei die Sensor-Schaltung (20) einen DC-Referenztreiber (22) zum Erzeugen eines DC-Referenzsignals, einen Sensor-Treiber (24) zum Erzeugen und Ausgeben eines AC-Signals an einem Ausgangsport (28) zum Speisen der Sensoren, mehrere Sensor-Ports (40) zum Anschluss an je einen Sensor, eine Schaltmatrix (30) zum Herstellen einer Verbindung der Sensor-Ports (40) mit den Treibern und eine DC-Entkopplung (62) zwischen Schaltmatrix (30) und kapazitiven Sensoren, zum DC-Entkoppeln von den kapazitiven Sensoren, umfassend einen Selbsttest mit den folgenden Schritten:
a Schließen des RT-Schalters (34) und des Sensor-Schalters (36)eines Schaltpfads für einen Sensor-Port (40);
b Öffnen des RT-Schalters (34) und des Sensor-Schalters (36)der anderen Schaltpfade der Schaltmatrix;
c Ausgeben eines DC-Referenzsignals an dem DC-Referenztreiber (22);
d Ausgeben eines DC-Signals an dem Sensor-Treiber (24), das sich von dem DC-Referenzsignal unterscheidet;
e Messen des an dem Stromausgangsport (29) des Sensor-Treibers (24) zur Verfügung gestellten Messstroms;
f Vergleichen des Messstroms mit einem Grenzwert.

16. Verfahren nach dem vorhergehenden Anspruch, **gekennzeichnet durch** die weiteren Schritte:
h Öffnen des RT-Schalters (34) und/oder des Sensor-Schalters (36) des einen Schaltpfads (38);
i optionales Wiederholen der Schritte c bis f des Anspruchs 15;

17. Verfahren nach Anspruch 15 oder 16, **gekennzeichnet durch** die weiteren Schritte:
- Öffnen des RT-Schalters (34) und des Sensor-Schalters (36) des einen Schaltpfads (38) der Schaltmatrix (30);
- Auswählen eines weiteren Schaltpfads.

18. Verfahren nach einem der Ansprüche 15 bis 17, umfassend die weiteren Schritte des Selbsttests:
- Öffnen des RT-Schalters (34) und des Sensor-Schalters (36) aller Schaltpfade (38) für die Sensor-Ports (40);
- Auswählen eines Sensor-Ports (40) zur Überprüfung des zugehörigen Switchload-Pfads (80);
- Öffnen der Switchload-Schalter (78) aller anderen Switchload-Pfade;
- Schließen des Sensor-Schalters (36) für den ausgewählten Sensor-Port (40);
- Schließen des Switchload-Schalters des ausgewählten Switchload-Pfads;
- Ausgeben eines DC-Schirm-Signals an dem Schirm-Treiber (70);
- Ausgeben eines DC-Signals an dem Sensor-Treiber (24), das sich von dem DC-Schirm-Signal unterscheidet;
- Messen des an dem Stromausgangsport (29) des Sensor-Treibers (24) zur Verfügung gestellten Messstroms;
- Vergleichen des Messstroms mit einem Grenzwert;

19. Verfahren nach dem vorhergehenden Anspruch, **gekennzeichnet durch** die weiteren Schritte:
- Öffnen des Switchload-Schalters (78) des ausgewählten Switchload-Pfads (80);
- Messen des an dem Stromausgangsport (29) des Sensor-Treibers (24) zur Verfügung gestellten Messstroms;
- Vergleichen des Messstroms mit einem Grenzwert.

20. Verfahren nach dem vorhergehenden Anspruch, **gekennzeichnet durch** die weiteren Schritte:
- Öffnen des Switchload-Schalters (78) und des Sensor-Schalters (36) für den ausgewählten Sensor-Port (40);
- Auswählen eines weiteren Switchload-Pfads (80);
- optionales Durchführen der Schritte nach Anspruch 18 oder 19 für den weiteren Switchload-Pfad.

21. Verfahren nach einem der Ansprüche 15 bis 20, **gekennzeichnet durch** die weiteren Schritte:
- Digitalisieren des Messstroms vor dem Vergleich mit dem Grenzwert;
- Prüfen, ob die gemessenen Stromwerte den jeweiligen Grenzwert einhalten;
- Ausgeben eines Validierungssignals an eine Steuereinheit (100).
